# EUROPEAN PATENT SPECIFICATION

(11) **EP 1 385 363 B1**
(45) Date of publication and mention of the grant of the patent: **21.05.2008**
(21) Application number: 02713291.9
(22) Date of filing: 04.04.2002
(51) Int. Cl.: H05K 1/11, H05K 3/40, H05K 3/46

(54) **PRINTED CIRCUIT BOARD AND PRODUCTION METHOD THEREFOR, AND LAMINATED PRINTED CIRCUIT BOARD**
LEITERPLATTE UND HERSTELLUNGSVERFAHREN DAFÜR UND LAMINIERTE LEITERPLATTE
CARTE DE CIRCUITS IMPRIMES ET PROCEDE PERMETTANT SA REALISATION, ET CARTE DE CIRCUITS IMPRIMES LAMINEE

(30) Priority: 06.04.2001 JP 2001108381
(43) Date of publication of application: 28.01.2004
(73) Proprietor: Mitsui Mining & Smelting Co., Ltd, Tokyo 141-8584 (JP); Suzuki Co., Ltd, Suzaka-shi, Nagano 382-8588 (JP)
(72) Inventor: HAYASHI, Katsuhiko, MITSUI MINING & SMELTING CO LTD, Ageo-shi, Saitama 362-0021 (JP); KATAOKA, Tatsuo, MITSUI MINING & SMELTING CO LTD, Ageo-shi, Saitama 362-00 (JP); KAWAMURA, Hirokazu, MITSUI MINING & SMELTING CO LTD, Ageo-shi, Saitama 362-0021 (JP); ICHIRYU, Akira, MITSUI MINING & SMELTING CO LTD, Ageo-shi, Saitama 362-0021 (JP)
(74) Representative: Whalley, Kevin
(86) International application number: PCT/JP2002/003379
(87) International publication number: WO 2002/085081

(56) References cited:
- GB-A- 1 284 197
- JP-A- 52 131 925
- JP-A- 59 140 343
- JP-A- 2000 196 235
- JP-A- 2000 272 977
- JP-A- 2000 332 369
- JP-A- 2001 068 808
- US-A- 3 528 803
- US-A- 4 396 467
- PATENT ABSTRACTS OF JAPAN vol. 2003, no. 12, 5 December 2003 (2003-12-05) & JP 2003 283083 A (KYOCERA CORP), 3 October 2003 (2003-10-03)
- PATENT ABSTRACTS OF JAPAN vol. 2000, no. 12, 3 January 2001 (2001-01-03) & JP 2000 243791 A (MITSUI MINING & SMELTING CO LTD), 8 September 2000 (2000-09-08)

## Description

The present invention relates to a printed circuit board, more particularly to a heat-resistant printed circuit board having a plurality of via-holes which are prepared by filling through-holes with heat-resistant implant material.

Various circuit boards are used having conductive layers (interconnect patterns) on their top and bottom surfaces. Practical examples thereof include a multi-layered interconnecting board having a rigid substrate made of glass epoxy in addition to a TAB (Tape Automated Bonding) tape, a CSP (Chip Size Package), a BGA (Ball Grid Array), and a FPC (Flexible Printed Circuit) having a substrate made of flexible polyimide resin.

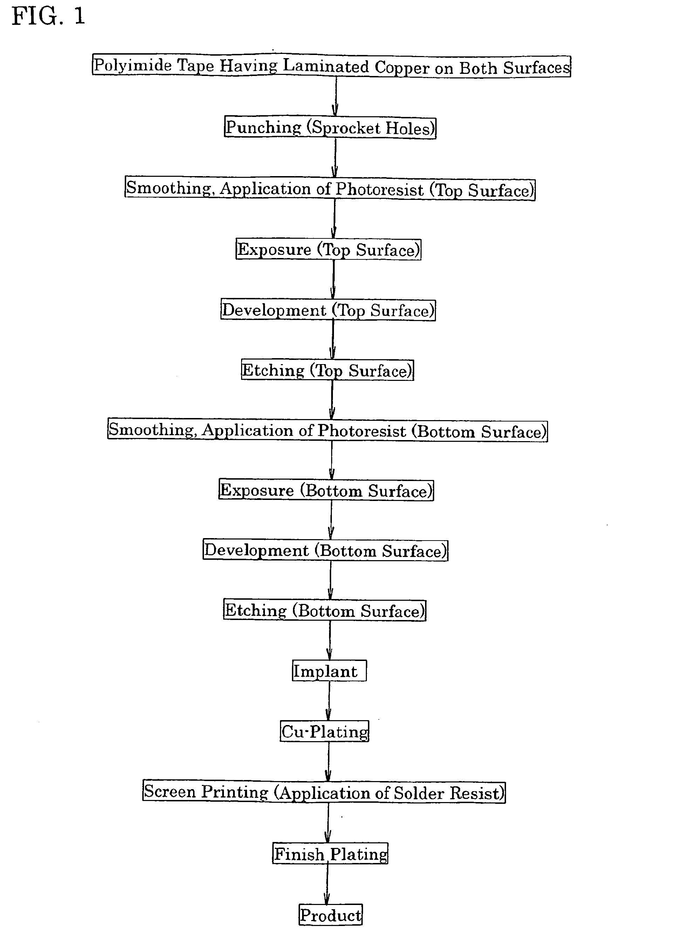

A printed circuit board having interconnect patterns on the top and bottom surfaces is fabricated, for example, in accordance with a conventional method shown in a flowchart of Fig.1.

At first, sprocket holes are formed, by punching, through specified positions of a polyimide tape having laminated copper on both of the surfaces. After the top surface of the polyimide tape is smoothened, photoresist applied on the top surface of the film is exposed and developed to form an etching mask. The copper on the film surface is etched by using the etching mask to form interconnect patterns. Similarly, interconnect patterns on the bottom surface of the polyimide tape are formed by the process of the smoothing, the application of a photoresist, exposure, development and etching.

Through-holes are perforated with a punching press machine at specified positions of the polyimide tape having the interconnect patterns formed in the above manner on the top and bottom surfaces. Then, the interconnect patterns on the top and bottom surfaces are electrically connected with each other. The electrical connection is performed by a punching-press of a tin-silver alloy or tin-copper alloy material superposed on the top and bottom surfaces of the polyimide tape to fill the through-holes followed by caulking with the punching-press machine. A printed circuit board having an ideal electric connection can be obtained by filling the through-holes having diameter of about 100 µm with a tin-silver alloy material.

However, the thermal resistance of the printed circuit board which is obtained in this manner is inferior and the tin-silver alloy or tin-copper alloy material as the implant material is likely to generate defects in the via-holes by the repetition of the heating and cooling. The printed circuit board disadvantageously lacks connection reliability between the interconnects on the top and bottom surfaces. The melting point of the tin-silver alloy or tin-copper alloy material is relatively low such that a problem may arise that degradation may occur when the material is heated to a temperature beyond the melting point. Although the improvement of the heat resistance is attempted by plating, with gold having underlying nickel, both ends of the via-holes filled with the above alloy material, the improvement is not necessarily sufficient. Satisfactory results may be obtained depending on the diameters of the through-holes and the kind of the implant material. However, the restriction of the plating material to gold having underlying nickel lowers the degree of freedom with respect to products although the use of another plating material is desirous depending on the intended use.

Thickening of the plating thickness of gold having underlying nickel is required to sufficiently elevate the heat resistance, thereby increasing the width of the interconnect patterns. Accordingly, the required miniaturization of the interconnects cannot be realized.

Attention is also drawn to JP-2001/68808A (which discloses the preamble of claim 1) and to JP-2001/196235A.

The present inventors have attained the present invention by providing a printed circuit board having excellent heat resistance after investigation of various materials which may be used as an implanting material which fills through-holes. An object of the present invention is to provide a printed circuit board which is usable for a longer period of time and has excellent heat resistance.

The above object is achieved by providing a print circuit board including a dielectric substrate having via-holes perforated therethrough, an implant material which is filled in the via-holes and selected from a group consisting of phosphorus-deoxidized copper, tough pitch copper, annealed oxygen free copper, annealed phosphorus-deoxidized copper and annealed tough pitch copper, and interconnect patterns formed on both surfaces of the substrate and electrically connected to the implant material.

Such a print circuit board can be fabricated by a process including the steps of perforating through-holes (basically, in the present invention, an aperture is referred to as a through-hole, and an aperture filled with an implant material is referred to as a via-hole) therethrough, filling the through-holes with an implant material to form via-holes, forming a pair of plated layers on both of top and bottom surfaces of the dielectric substrate including both surface ends of the filled implant materials, and forming interconnect patterns on the plated layers.

In accordance with the print circuit board of the present invention, a print circuit board having excellent heat resistance can be obtained and used for a longer period of time because the via-holes made of the annealed oxygen free copper, the (optionally annealed phosphorus-deoxidized copper, or the (optinally annealed) tough pitch copper reduce the probability of generating deficiencies under the conditions of repeated heating and cooling between higher temperatures and lower temperatures to which the print circuit board is likely to be exposed.

Annealing of oxygen free copper, phosphorus-deoxidized copper or tough pitch copper in advance improves the extendibility and the filling ability, thereby providing a print circuit board having higher performances.

A plated layer may be formed in contact with the implant material filled in the via-holes, thereby further improving the conductivity between the interconnect patterns on the top and bottom surfaces of the print circuit board of the present invention.

The plated layer is desirably a copper plated layer, and a thickness of 1µ m or more thereof effectively prevents the generation of cracks.

A plurality of the print circuit boards may be stacked to provide a layered print circuit board.

In accordance with the process of fabricating the print circuit board, interconnect patterns having extremely smaller width can be easily formed because the via-holes are formed before the formation of the interconnect patterns or because the interconnect patterns can be freely formed on the conductive plated layer.

As described above, the present invention is characterized by the use of the annealed oxygen free copper, the (annealed) phosphorus-deoxidized copper or the (annealed) tough pitch copper having excellent heat-resistance singly or a combination thereof, or by the use thereof with a relatively smaller amount of another material.

The annealed oxygen free copper contains 0.005 % or less of oxygen for preventing hydrogen embrittlement. The oxygen free copper is also referred to as OFHC (oxygen free high conductivity copper) and can be prepared in a vacuum melting furnace or an induction furnace having a reductive atmosphere.

The (annealed) phosphorus-deoxidized copper contains an extremely lower amount of oxygen, which is prepared by deoxidation or by removing the oxygen as oxide such as P₂O₅, thereby remaining a smaller amount of the phosphorous.

The (annealed) tough pitch copper containing a small amount of oxygen (0.02 to 0.05 %) as Cu₂O refers to refined copper, which is prepared by melt-refining electrolytic copper in a reflection furnace to leave the oxygen therein at about 0.02 % and then removing, as their oxides, impurities such as As, Sb and P.

These coppers generally contain about 0 to 0.05 % of oxygen and a smaller amount of other impurities, have higher heat-resistance than the tin-silver alloy material and the tin-copper alloy material conventionally used for filling the through-holes, and elevate the heat-resistance of the print circuit board at 260 °C which is a reflow temperature for mounting soldering balls. The use of oxygen free copper, phosphorus-deoxidized copper or tough pitch copper annealed in advance further increases the effect.

While the through-holes can be conveniently and most desirably formed by means of punching, a drill or laser may also be used. The use of the laser requires the removal of smear generated with the heat of the laser.

While the implant material can be filled in the through-holes by using any method, the filling is desirably conducted by punching with a punching-press machine or a punching mold which is the same as that used for the conventional through-hole formation. In addition, a screen printer may be used.

When the through-hole formation and the implant material filling are conducted as a single punching operation, the top end of the formed via-hole is liable to be rounded to decrease the conductivity reliability. Accordingly, after the through-hole formation, the implant material is desirably filled in the through-holes.

A print circuit board having material used in the ordinary print circuit board can be used without restriction as the print circuit board of the present invention, and the use of polyimide resin is desirable. The material of and the method of forming the interconnect patterns are not especially restricted, and the desired interconnect patterns may be prepared by smoothing of the copper plated layer, masking by the application of photoresist, exposure, development, and etching.

The number of the through-holes to be formed depends on the number of the interconnect patterns to be electrically connected and their positional relationship, and their diameters are desirably minimum provided that sufficient electrical connection is secured.

The conductive plated layer, for example, a copper plated layer, is desirably coated on the surface of the interconnect patterns made of copper or the like, and the formation of the plated layer further increases the reliability of the electrical connection.

The conductive plated layer is desirably formed before the formation of the interconnect patterns, thereby freely forming the interconnect patterns on the conductive plated layer or enabling the easier formation of the interconnect patterns having extremely smaller width.

The print circuit board of the present invention which has the via-holes filled with the implant material which is selected from the group consisting of the annealed oxygen free copper, the (annealed) phosphorus deoxidized copper and the (annealed) tough pitch copper, ordinarily has a via-hole resistance below 3 mΩ /hole depending on the fabrication conditions, and obtains extremely excellent conductivity.

In accordance with the process in which the conductive plated layer is formed before the interconnect pattern formation, the interconnect patterns can be freely formed on the conductive plated layer and interconnect patterns having extremely smaller width can be easily formed.

The invention will be further described with reference to one accompanying drawings, wherein
Fig.1 is a flowchart showing a conventional process for fabricating a print circuit board having interconnect patterns on its top and bottom surfaces.
Fig.2 is a vertical sectional view exemplifying a series of process steps for fabricating 2-metal TAB or the print circuit board.
Fig.3 is a top plan view showing the 2-metal TAB of an embodiment.

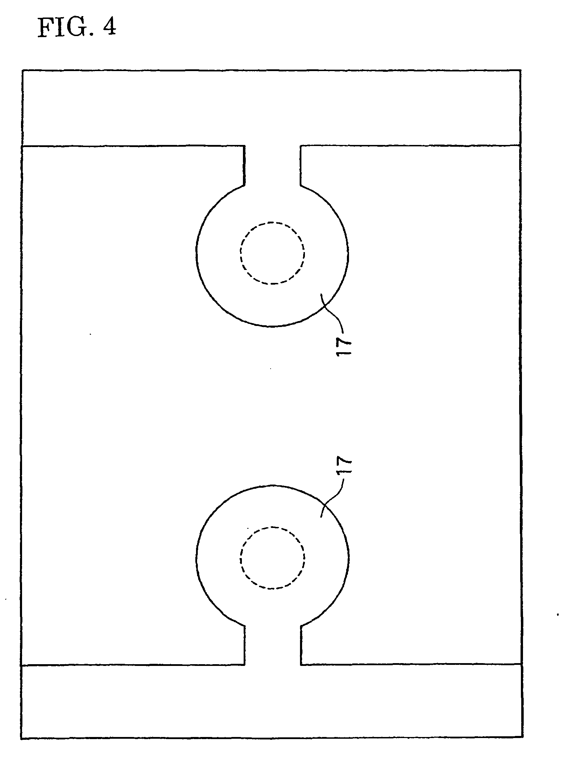

Fig.4 is an enlarged view showing a land section of the 2-metal TAB of Fig.3.

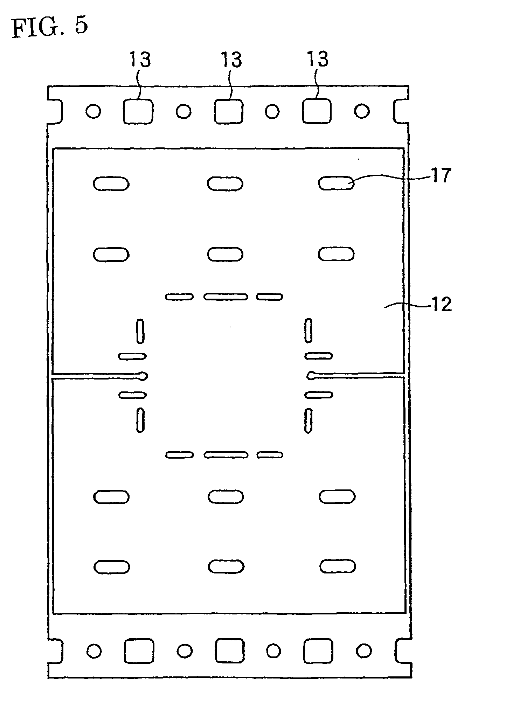

Fig.5 is a bottom view showing the 2-metal TAB of the embodiment.

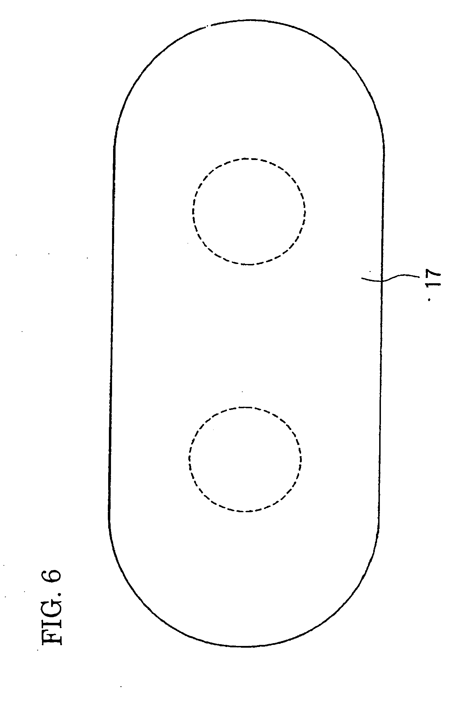

Fig.6 is an enlarged view showing a land section of the 2-metal TAB of Fig.5.
Fig.7 is a vertical sectional view showing a print circuit board having a relatively thicker copper plated layer.
Fig.8 is a vertical sectional view showing a print circuit board having a relatively thinner copper plated layer.

Although an embodiment of a process of fabricating a print circuit board in accordance with the present invention will be described referring to the annexed drawings, the present invention shall not be deemed to be restricted thereto.

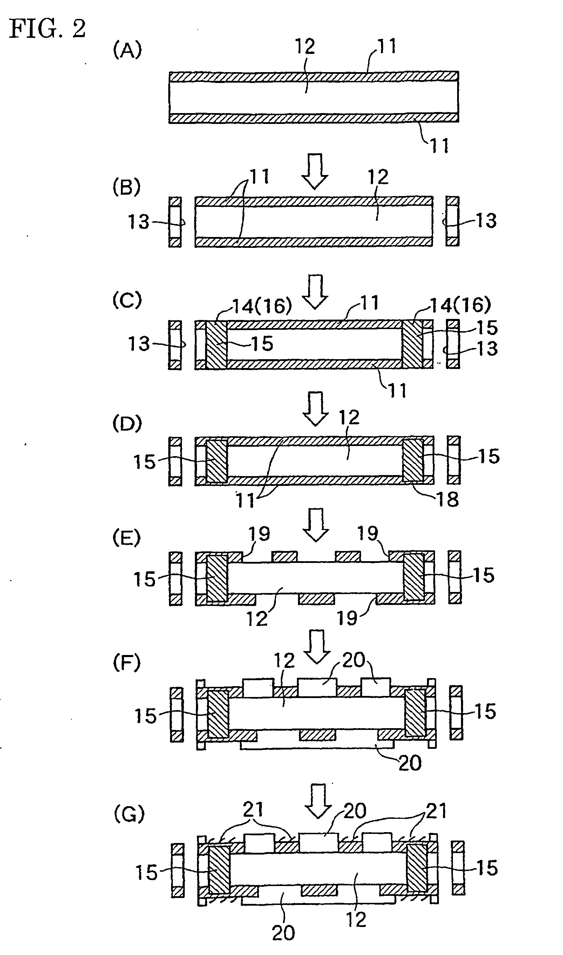

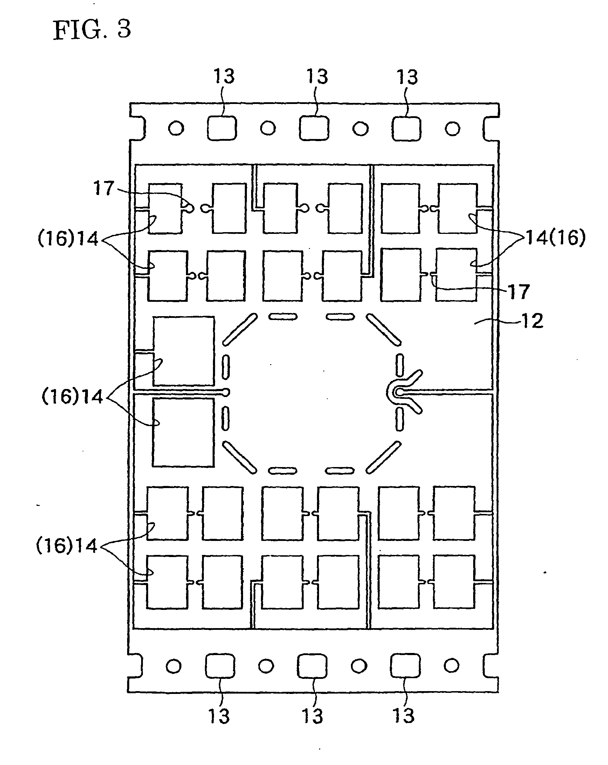

Sprocket holes 13 are perforated (Fig.2B), by punching, through specified positions, corresponding to sprocket holes 13 of Fig.2, of a polyimide film 12 having laminated copper layer 11 on both of top and bottom surfaces (Fig.2A). After through-holes 14 are perforated, by punching, through specified positions, corresponding to through-holes 14 of Fig.3, of the polyimide film 12, highly heat-resistant implant material strips such as oxygen free copper are superposed on the top and bottom surfaces of the polyimide film 12 followed by the punching to fill the through-holes with the implant material 15 to make via-holes 16 and to simultaneously form land sections 17 (Fig.2C and Fig.3). In this situation, the surfaces of the polyimide film 12 and the via-holes 16 are matched.

Then, a copper plated layer 18 is formed on the matched surface (Fig.2D). After the copper plated layer 18 is smoothened and photoresist is applied on the top surface thereof followed by exposure and development for making a mask, the etching is conducted by using the mask to form trenches 19 on the top surface of the polyimide film 12. Further, trenches 19 are similarly formed on the bottom surface of the polyimide film 12 (Fig.2E). At this stage, the trenches can be formed relatively freely because the copper plated layer has been already covered.

Solder resist 20 is formed such that the trenches 19 of the top and bottom surfaces of the polyimide film are filled and the solder resist is projected from the surfaces (Fig.2F), and a finished plated layer 21 is formed on the surface other than the solder resist 20 to provide a print circuit board (Fig.2G).

The print circuit board fabricated in this manner has a reduced probability of generating deficiencies under the conditions of repeated heating and cooling between higher temperatures and lower temperatures because the via-holes are made of the highly heat-resistant implant material 15.

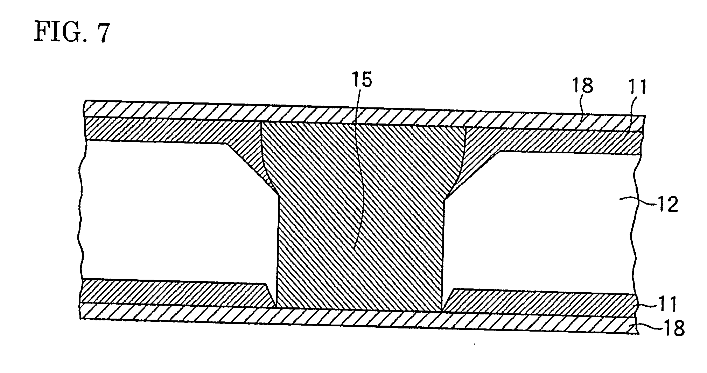

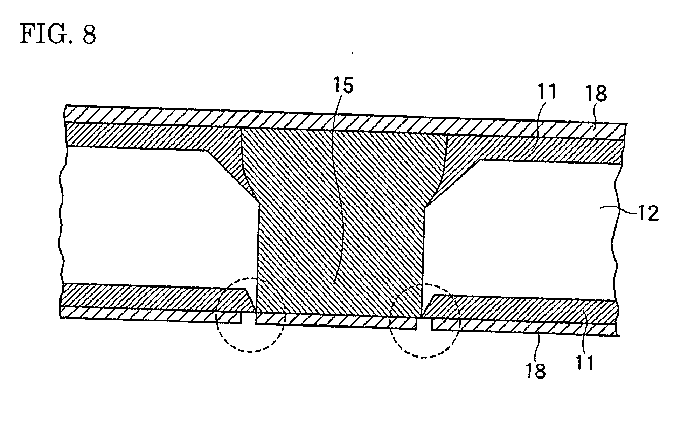

Further, satisfactory conductivity is secured for a longer period of time because the copper plated layer 18 ensures the reliability of the electric connection with the via-holes 16. While a relatively thicker copper plated layer 18 seldom generates cracks under conditions of repeated heating and cooling between higher temperatures and lower temperatures as shown in Fig.7, a relatively thinner copper plated layer 18 may generate cracks under conditions of repeated heating and cooling between higher temperatures and lower temperatures as shown in Fig.8. However, when the copper plated layer 18 is desirably formed relatively thicker for example, in a thickness of 1 µm or more, the cracks which cause harmful effects on the performance of the print circuit board seldom occur, and no problem arises under normal operation.

The process of forming the via-holes before making the circuit patterns is described in the present embodiment, though the fabrication process of the print circuit board of the present invention is not restricted to the process of the above mentioned. The conventional fabrication shown in Fig.1 is also used.

Although Examples of the fabrication of the print circuit board will be described in accordance with the present invention, the present invention shall not be deemed to be restricted thereto.

### Example 1

A polyimide film with a width of 35mm (thickness of polyimide layer was 50 µm; the thicknesses of the laminated copper on the top and bottom surfaces were 12 µm; and tradename name of Nippon Steel Corporation was "Espanex") having laminated copper on both of the surfaces was used as a tape.

Sprocket holes were perforated through the tape by using a punching-press machine. Then, through-holes having a diameter of about 100µm were perforated by using the punching-press machine.

An annealed oxygen free copper strip having a thickness about 120 mm was superposed on the top and bottom surfaces of the tape, and the annealed oxygen free copper was implanted into the through-holes by the re-punching-press. After the removal of the surplus implanted material by etching, the surface of the tape was copper-plated by using a copper sulfate plating bath under current density of 10A/dm² to form a copper plated layer having a thickness of about 6µm.

Then, interconnect patterns were formed by etching the top and bottom surfaces in accordance with an ordinary method to provide a print circuit board. In this stage, fine pitch patterns could be formed and the copper plated layer could be wired relatively freely.

The resistance of the via-holes between the top and bottom surfaces of the print circuit board should be below 3mΩ/hole to provide sufficient conductivity for the 2-metal TAB or the like.

A hot oil test was conducted by dipping the circuit board in hot oil heated to 260 °C for five seconds and immediately thereafter dipping in the oil at 23 °C for 20 seconds; this was repeated 100 times. After the test, the connection reliability between the interconnect via-holes made by implant process was found to be sufficient and no cracks were observed on the copper plated layer.

### Example 2

A print circuit board was fabricated under the same conditions as described in Example 1 except that the thickness of the copper plated layer was 1 µm.

The resistance of the via-holes between the top and bottom surfaces of the obtained print circuit board was measured to be below 3mΩ/hole.

The hot oil test was conducted under the same conditions as those of Example 1. After the test, the connection reliability between the interconnect patterns on the top and bottom surfaces of the circuit board was maintained. However, cracks were observed on the copper plated layer.

### Example 3

A print circuit board was fabricated under the same conditions as those of Example 1 except that phosphorus-deoxidized copper was used in place of the annealed oxygen free copper as the implant material.

The resistance of the via-holes between the top and bottom surfaces of the obtained print circuit board was measured to be below 3mΩ/hole.

The hot oil test was conducted under the same conditions as those of Example 1. The connection reliability between the interconnect patterns on the top and bottom surfaces of the circuit board was maintained, and no cracks were observed on the copper plated layer.

### Example 4

A print circuit board was fabricated under the same conditions as those of Example 1 except that tough pitch copper was used in place of the annealed oxygen free copper as the implant material.

The resistance of the via-holes between the top and bottom surfaces of the obtained print circuit board was measured to be below 3mΩ/hole.

The hot oil test was conducted under the same conditions as those of Example 1. The connection reliability between the interconnect patterns on the top and bottom surfaces of the circuit board was maintained, and no cracks were observed on the copper plated layer.

### Example 5

A polyimide film with a width of 35mm (thickness of polyimide layer was 50 µm; the thicknesses of the laminated copper on the top and bottom surfaces were 18 µm; and tradename name of Nippon Steel Corporation was "Espanex") having laminated cooper on the top and bottom surfaces was used as a tape.

Then, interconnect patterns were formed by etching on the top and bottom surfaces of the tape in accordance with an ordinary method. In this stage, the interconnect patterns on the top and bottom surfaces are not electrically connected with each other.

Sprocket holes and through-holes were perforated through the tape similarly to Example 1.

After films made of annealed oxygen free copper having a thickness about 0.12 mm were superposed on the top and bottom surfaces of the tape, the annealed oxygen free copper was embedded in the through-holes by the re-punching-press. After the removal of the surplus oxygen free copper film, the surface of the tape was copper-plated by using a copper sulfate plating bath under current density of 10A/dm² to form a print circuit board having a copper plated layer with a thickness of about 6 µ m.

The resistance of the via-holes between the top and bottom surfaces of the print circuit board thus obtained was measured to be below 3mΩ/hole which provided sufficient conductivity for the 2-metal TAB or the like.

The hot oil test was conducted under the same conditions as those of Example 1. The connection reliability between the interconnect patterns on the top and bottom surfaces of the circuit board was maintained, and no cracks were observed on the copper plated layer.

### Comparative Example 1

A print circuit board was fabricated under the same conditions as those of Example 5 except that the diameter of the through-holes was about 100 µm, and the through-holes were filled with a tin-silver alloy material film having a thickness of 0.10 mm in place of the annealed oxygen free copper.

The resistance of the via-holes between the top and bottom surfaces of the print circuit board thus obtained was measured to be below 10mΩ/hole. This resistance was larger than the resistances of the print circuit boards of the Examples. However, the conductivity in the range used for the 2-metal TAB or the like could be obtained.

The hot oil test was conducted under the same conditions as those of Example 5. Cracks were generated in the via-holes, and the via-holes did not have sufficient heat-resistance.

## Claims

1. A print circuit board comprising a dielectric substrate (12) having via-holes (16) perforated therethrough, an implant material (15) filled in the via-holes (16), and interconnect patterns formed on both surfaces of the substrate (12) and electrically connected to the implant material (15), **characterized in that** the implant material (15) is selected from a group consisting of phosphorus-deoxidized copper, tough pitch copper, annealed oxygen free copper, annealed phosphorus-deoxidized copper and annealed tough pitch copper.

2. A print circuit board as claimed in claim 1, **characterized by** further comprising a plated layer (18) in contact with the implant material (15) filled in the via-holes (16).

3. A print circuit board as claimed in claim 2, **characterized in that** the plated layer (18) is a copper plated layer having a thickness of 1 µm or more.

4. A multi-layered print circuit board comprising a plurality of stacked print circuit boards as claimed in any of claims 1 to 3.

## Patentansprüche

1. Leiterplatte, umfassend: ein Isoliersubstrat (12) mit Durchgangsbohrungen (16), die dort durchgelocht sind, ein Implantationsmaterial (15), das in die Durchgangsbohrungen (16) gefüllt ist, und Verbindungsstrukturen, die auf beiden Oberflächen des Substrats (12) gebildet sind und elektrisch mit dem Implantationsmaterial (15) verbunden sind, **dadurch gekennzeichnet, dass** das Implantationsmaterial (15) aus einer Gruppe ausgewählt ist, die aus den Folgenden besteht: phosphorhaltigem desoxidiertem Kupfer, zähgepoltem Kupfer, weichgeglühtem sauerstofffreiem Kupfer, weichgeglühtem phosphorhaltigem desoxidiertem Kupfer und weichgeglühtem zähgepoltem Kupfer.

2. Leiterplatte nach Anspruch 1, **dadurch gekennzeichnet, dass** sie außerdem eine plattierte Lage (18) umfasst, die mit dem in die Durchgangsbohrungen (16) gefüllten Implantationsmaterial (15) Kontakt hat.

3. Leiterplatte nach Anspruch 2, **dadurch gekennzeichnet, dass** die plattierte Lage (18) eine kupferplattierte Lage mit einer Dicke von mindestens 1 µm ist.

4. Mehrlagenleiterplatte, eine Vielzahl von gestapelten Leiterplatten nach einem der Ansprüche 1 bis 3 umfassend.

## Revendications

1. Carte de circuit imprimé comprenant un substrat diélectrique (12) comportant des trous de via (16) perforés au travers, un matériau d'implant (15) remplissant les trous de via (16) et des motifs d'interconnexion formés sur les deux surfaces du substrat (12) et connectés électriquement au matériau d'implant (15), **caractérisée en ce que** le matériau d'implant (15) est choisi parmi un groupe comprenant cuivre désoxydé au phosphore, cuivre contenant de l'oxygène, cuivre sans oxygène recuit, cuivre désoxydé par phosphore recuit et cuivre contenant de l'oxygène recuit.

2. Carte de circuit imprimé selon la revendication 1, **caractérisée en ce qu'**elle comprend en outre une couche plaquée (18) en contact avec le matériau d'implant (15) remplissant les trous de via (16).

3. Carte de circuit imprimé selon la revendication 2, **caractérisée en ce que** la couche plaquée (18) est une couche plaquée de cuivre présentant une épaisseur d'1 µm ou plus.

4. Carte de circuit imprimé multicouche comprenant une pluralité de cartes de circuit imprimé empilées telles que revendiquées selon l'une quelconque des revendications 1 à 3.
